# EUROPEAN PATENT APPLICATION

(11) **EP 1 487 122 A1**
(43) Date of publication of application: **15.12.2004**
(21) Application number: 03425382.3
(22) Date of filing: 12.06.2003
(51) Int. Cl.: H04B 1/28, H04L 27/38

(54) **Digital radio receiver**

(71) Applicant: STMicroelectronics S.r.l., 20041 Agrate Brianza (Milano) (IT)
(72) Inventor: Adducci, Francesco, 20161 Milano (IT); Boarin, Gianluigi, 27011 Belgioioso (IT); Stefani, Fabrizio, 21010 Cardano al Campo (IT); Sala, Michele, 10024 Moncalieri (IT); Salidu, Fabrizio, 15063 Cassano Spinola (IT)
(74) Representative: Pellegri, Alberto

(57) **Abstract**

A digital radio receiver achieves an outstandingly performance in terms of high signal/noise ratio by first converting a received radio frequency signal to a signal at an intermediate frequency by a fully analog tuning stage, thus avoiding to introduce any digital conversion noise before down-converting at intermediate frequency the radio signal.

The resulting digital signal is down-converted for generating in-phase and quadrature components that are filtered and eventually equalized by a programmable digital signal processor for compensating variations of the broadcast channel that may negatively affect the performance, especially in car radio applications.

## Description

### FIELD OF THE INVENTION

The present invention relates to radio receivers and in particular to a digital radio receiver for car radio applications.

### BACKGROUND OF THE INVENTION

A radio communication system comprises a transmitter, a receiver and a wireless communication channel. A signal to be transmitted is modulated in an analog fashion about a carrier frequency suitable to be broadcast over a radio frequency (RF) channel.

At a receiver, the received RF signal is first converted to a certain intermediate frequency (IF), typically 10.7 MHz for FM signals, by using a locally generated sinusoidal waveform and thereafter the IF signal is filtered and processed for extracting the transmitted signal.

The above operations may be performed either by analog or digital circuitry. An analog radio receiver requires expensive discrete components, such as ceramic filters, and the signal is rigidly processed according to an algorithm established by the hardware of the receiver. Therefore, an analog receiver for both FM and AM signals, must necessarily have a FM and an AM demodulator and does not permit any significant flexibility in signal processing.

By contrast, digital radio receivers are much more flexible than analog receivers because the received RF signal is converted in an IF digital signal and the IF digital signal is processed by a digital circuitry. This approach is convenient because the IF signal is demodulated, noise-filtered, stereo-decoded etc. only by digital circuits, which may easily perform both AM and FM demodulations and may be re-programmed for performing any kind of processing algorithm.

Known digital receivers may be implemented with three integrated circuits or even with a more complex single chip in case of dual-antenna applications. Generally, the signal processing is performed in a selected mode implemented by circuits designed accordingly.

A review of known digital radio receivers is provided in [1].
[1] Steve Byrd, "Software Radio using the Valley Technologies VT-1406 Dual Channel Narrowband Digital Receiver", Valley Technologies Engineering Department, document 590-001-001/1.0

The published patent application US 2002/0058491, by B.J. Minnis, discloses a radio receiver configurable to operate in either a low-IF or zero-IF mode comprising a quadrature down-converter for generating in-phase and quadrature signals at a certain intermediate frequency (IF). The in-phase and quadrature components are filtered by an image rejection filter, converted into corresponding digital signals and finally processed by a down-converter, which generates corresponding base-band signals.

Unfortunately, this radio receiver does not support a flexible processing of the received signals.

The patent US 6,112,069, by Bp-Gyu Na, discloses an analog radio receiver and a relative method for efficiently preventing attenuation of low frequency signals. This radio receiver employs two mixers realized with multipliers for processing the in-phase and the quadrature components of the received signal.

A drawback of this receiver is the fact that the received signal is never converted in a digital signal, in fact the receiver is composed of analog circuits and thus the processing of the received signal is unmodifiable.

The patent US 5,757,794, by W.R. Young, discloses a digital down converter with a programmable mixing down frequency and a programmable extraction bandwidth, using a ROM based sine/cosine generator plus a programmable high decimation filter followed by a gain compensating scaling multiplier and a fixed FIR filter.

A characteristic of this converter consists in that the in-phase and quadrature components of the input signal are obtained through multiplications by sine/cosine waveforms, generated by a Read Only Memory. Unfortunately, this down-converter does not have a sufficiently accurate frequency resolution.

The patent US 5,493,581, by W.R. Young et al., discloses a digital down-converter for extracting a signal from a complex digital signal, wherein the real and imaginary components of the complex digital signal are modulated to shift the center frequency of the desired signal to zero, digitally decimated to limit the bandwidth of each component to the bandwidth of the desired signal and finally filtered to modify the shape thereof.

This digital down converter has fixed working frequencies, data format and filtering. Moreover, the complex input signal is decomposed in in-phase and quadrature components through multiplications by sine/cosine waveforms. Like the digital-down converter of the preceding patent, the frequency resolution of this converter is not sufficiently accurate.

The patent US 5,603,017, by G. Intrater et al., discloses an integrated circuit with a parallel architecture having a DSP (Digital Signal Processor) and a CPU core operable for switching between two independent asynchronous clock sources while the system continues executing instructions.

The patent US 5,982,823, by W. E. Jacklin, discloses a method and a coarse tuning circuit for performing direct frequency selection and down-conversion on a received analog band-pass signal for a digital receiver. The disclosed circuit may be employed in high quality radio transmissions systems (15 kHz audio band, high signal/noise ratio, very low distortion). This circuit is conveniently usable in transmission systems in which a transmitter broadcasts a signal obtained by modulating a carrier with a digital signal.

Unfortunately, it is not satisfactory for HI-FI car radio applications because it does not compensate the undesired effects of changes of the broadcast channel, which are relevant in these applications.

The patent US 5,606,714, by G. Intrater et al., discloses a processor system that integrates the functions of both a general purpose CPU core and an independently operating digital signal processor, and wherein the processor is operable in three different functioning modes.

The patent US 5,675,751, by R.G. Baker et al., discloses a computer system having a peripheral bus and a digital signal processor local bus interfacing with the peripheral bus via an extended bus interface circuit. The DSP local bus is configured such that devices, which are typically two or more DSPs, electrically connected to the DSP local bus may transfer data to other devices connected to the DSP local bus, regardless of data transfer activity on the peripheral bus.

The patent US 6,029,221, by Y.J.W. Wu et al., discloses an audio bus interface and a method for interfacing a plurality of digital signal processing devices with an audio bus in order to facilitate the loading of different processing algorithms on the DSPs.

The patent US 6,438,622, by S. Haghighi, discloses a system including a docking base unit having a first processor and a portable computing device including a second processor that is dockable to the docking base unit. A module identifies the number of processors in the system once the portable computing device is docked to the docking base unit and configures the system as a multiprocessor system if more than one processor is identified.

The published patent application US 2002/0193140, by R.T. Behrens et al., discloses a radio-frequency receiver having a receiver analog circuitry that converts the received RF signal in an IF digital signal, a digital circuitry coupled to the analog circuitry through a one-bit digital interface down-converts the IF digital signal by mixing it with a local oscillator signal of intermediate frequency (IF). Finally the down-converted digital signal is filtered to generate a filtered digital signal.

The receiver allows to process a received signal with a certain flexibility, but the corresponding demodulated signal is corrupted by a relatively intense noise that worsen significantly the signal/noise ratio.

### OBJECT AND SUMMARY OF THE INVENTION

It has been found that the signal/noise ratio of the known radio receivers is relatively high when the tuning stage is fully analog instead of being a mixed-technology analog-digital tuning stage.

By investigating on the noted phenomenon, a probable reason why the receiver of the patent US 2002/0193140 is affected by a relevant noise could be that the tuning stage is not entirely analog, on the contrary it is composed of an analog receiving circuitry that is coupled to a digital down-converter through a one-bit digital interface. It has been assumed that the noise generated during the analog-to-digital conversion could corrupt the signal to be demodulated before converting it to the intermediate frequency, thus worsening sensibly the performances of the whole receiver.

Investigation on the reasons of such an observation have led the present applicants to devise a digital radio receiver that achieves an outstandingly performance in terms of high signal/noise ratio by first converting a received radio frequency signal to a signal at an intermediate frequency by a fully analog tuning stage, thus avoiding to introduce any digital conversion noise before down-converting at intermediate frequency the radio signal.

The resulting digital signal is down-converted for generating in-phase and quadrature components that are filtered and eventually equalized by a programmable digital signal processor for compensating variations of the broadcast channel that may negatively affect the performance, especially in car radio applications.

Further investigations on the digital down-converter of patents US 5,757,794 and US 5,493,581 showed that the insufficiently accurate frequency resolution of these converters is probably due to the fact that the intermediate frequency digital signals are decomposed in corresponding in-phase and quadrature low frequency digital signals through multiplications by sine/cosine waveforms.

In order to have an accurate frequency resolution, the digital down-converter of this invention comprises a coordinate rotator-derotator for decomposing the intermediate frequency digital signals in corresponding in-phase and quadrature digital signals.

More precisely, object of this invention is a radio frequency receiver, comprising
- a fully analog input tuning stage receiving radio frequency signals and generating corresponding intermediate frequency analog signals;
- an analog-to-digital converter of the intermediate frequency analog signals generating corresponding digital signals of intermediate frequency;
- a programmable digital signal processor managing the functioning of the receiver for generating demodulated digital signals;
- an input interface coupled to said programmable digital signal processor for connecting it to an external device storing the software program to be run;
- a digital down-converter of the intermediate frequency digital signals, controlled by the programmable digital signal processor through a common bus, comprising at least a coordinate rotator-derotator decomposing the intermediate frequency digital signals in corresponding in-phase and quadrature low frequency digital signals;
- a second coordinate rotator-derotator input with the filtered digital low-frequency signals or with an equalized replica thereof, providing to the digital signal processor, through the common bus, signals representing phase, magnitude and differential phase of the complex signal represented by the in-phase and quadrature digital low-frequency signals.

The invention is defined in the annexed claims.

### BRIEF DESCRIPTION OF THE DRAWINGS

The different aspects and advantages of this invention will become even more evident through a detailed description referring to the attached drawings, wherein:
**Figure 1** is a general scheme of a digital radio receiver of this invention;
**Figure 2** is a basic block diagram, illustrating the architecture of the core of an AM/FM stereo radio receiver of this invention;
**Figure 3** is a more detailed view of the diagram of Figure 2;
**Figure 4** is a detail view of several functional circuits of the receiver of Figure 3.

### DESCRIPTION OF A PREFERRED EMBODIMENT OF THE INVENTION

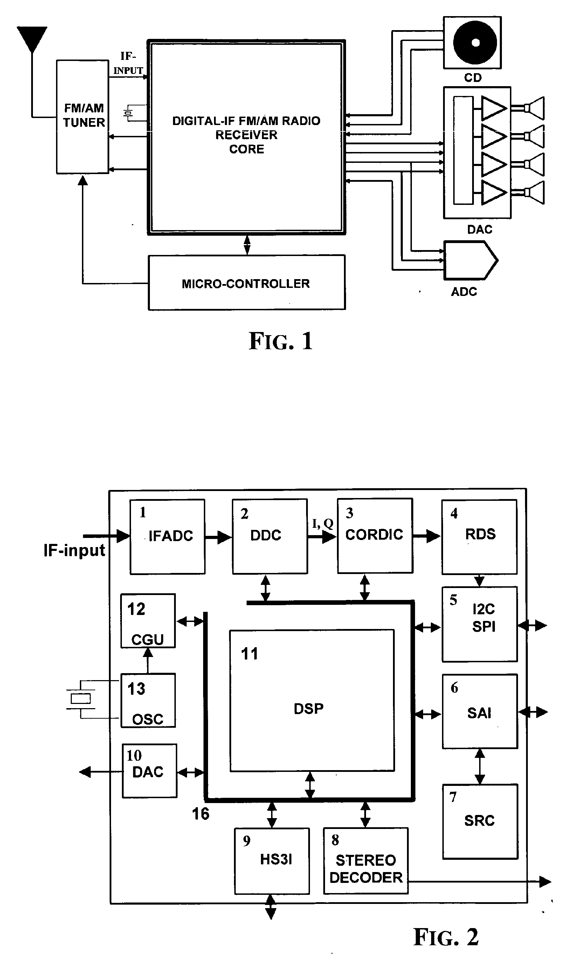

The digital radio receiver of this invention, depicted in Figure 1, has an input tuning stage FM/AM TUNER composed exclusively of analog circuits.

The received radio frequency signal is converted in an intermediate frequency signal IF-INPUT without corrupting it with digital conversion noise, as it happens in known receivers. Thereafter, the signal IF-INPUT is fed to an input of the core of the receiver for converting it in a digital signal, which is then digitally processed.

An embodiment of the core of the receiver of this invention is depicted in Figure 2.

The intermediate frequency signal IF-INPUT, both if it is an AM or FM signal, is converted into a digital signal by an analog-to-digital converter IFADC and is processed by a digital down-converter DDC, interfaced through an internal bus 16 with a programmable digital signal processor DSP, which manages the functioning of the receiver and generates demodulated digital signals.

The fact that the functioning of the receiver is based on the use of a programmable digital signal processor DSP allows the maximum flexibility in processing received RF signals, which may be easily demodulated or equalized.

The digital down-converter DDC converts the digital replica of the signal IF-INPUT in corresponding in-phase I and quadrature Q low-frequency digital signals, filtered from noise and from accidental channel distortions. In order to have a sufficiently accurate frequency resolution, these in-phase I and quadrature Q low-frequency digital signals are generated by a dedicated coordinate rotator-derotator (not shown in Figure 2) and not by multiplying the signal IF-INPUT by sine/cosine waveforms.

Preferably these signals I and Q are also subjected to a channel equalization process, carried out by the programmable digital signal processor, in order to compensate variations of the transfer function of the transmission channel. This feature is particularly important in HI-FI car radio applications, which are particularly sensitive to this problem.

The in-phase I and quadrature Q signals generated by the converter DDC or by the processor DSP (if a programmable adaptive equalization of the transmission channel is required) are input to a coordinate rotator-derotator CORDIC, which converts from Cartesian to polar coordinates.

The output of the block CORDIC consists in a triplet of signals (27, 28 and 29 in Figure 4) representative of the phase, the module and the differential phase of the complex quantity I+*i**Q, where I and Q are the in-phase and quadrature signals, respectively, and "*i*" is the imaginary unit.

Optionally, the receiver of this invention has a circuit block RDS input with the signals generated by the block CORDIC, for decoding eventual Radio Data Service signals that may be broadcast by certain FM radio stations. These decoded signals are sent to an external microcontroller (depicted in Figure 1) through a digital interface 5, which may be an SPI or an I2C interface. This interface may be also used for loading the program to be run by the digital signal processor DSP.

In the embodiment of Figure 2, there is also a serial audio interface SAI that receives or transmits audio data from or to the processor DSP. Preferably the serial audio interface SAI is connected to a sample rate converter SRC for modifying the sample rate of the transmitted data, when so required by the processor DSP.

Given that the receiver of this invention is mainly addressed to HI-FI applications, it is provided also of a dedicated block STEREO DECODER, coupled to the processor DSP through the common internal bus 16, for decoding the received FM stereo signals in cooperation with the DSP.

Another important option of the receiver of this invention consists in that a high speed interface HS3I may be provided for coupling the radio receiver with other identical receivers in order to enhance the signal processing by providing to the same processor DSP signals coming from two or more different antennas (high-end applications).

Preferably, the processor DSP generates also a digital feedback signals for the input tuning stage representative of the intensity of the received radio signal. This signal is converted by a digital-to-analog converter DAC, that generates a corresponding analog signal for automatically controlling the gain (AGC) of the input tuning stage.

Finally a clock generation unit CGU, coupled to an oscillator OSC, provides a timing clock signal to the digital signal processor DSP.

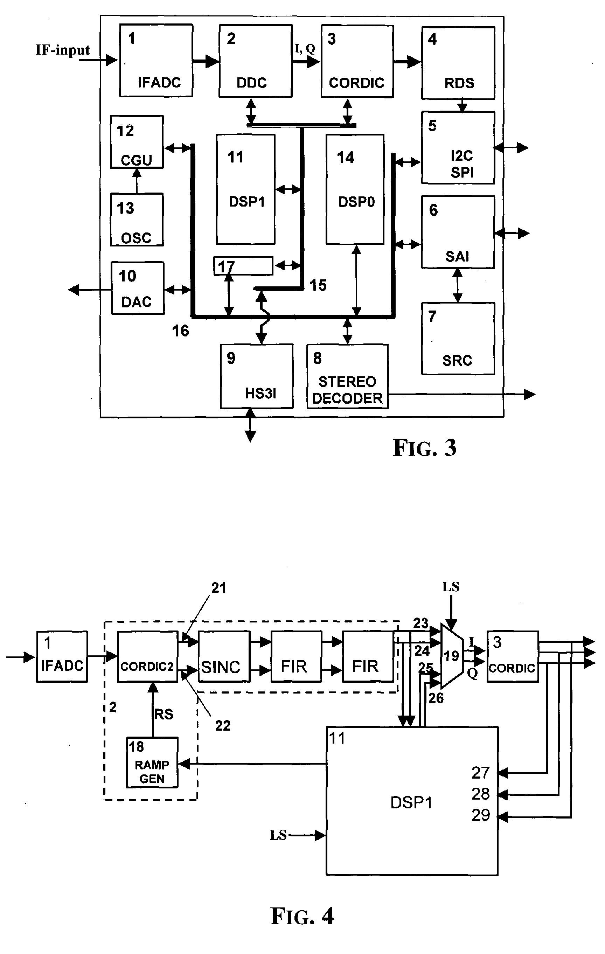

Preferably, the radio receiver of this invention comprises two distinct processors DSP1, DSP0, as shown in Figure 3, connected to respective buses 15, 16 and an interface 17 for coupling them. One of the two processors, DSP1, is specifically dedicated to the management of filtering and equalization operations, while the other processor, DSP0, is dedicated to process FM stereo signals and for controlling the gain of the input tuning stage (AGC).

A detailed view of a preferred embodiment of the digital down-converter of the radio receiver of this invention is depicted in Figure 4. Substantially the digital down-converter is composed of the aforementioned coordinate rotator-derotator CORDIC2 input with the intermediate frequency digital signal for generating corresponding in-phase (21) and quadrature (22) low-frequency digital signals, and a digital filtering circuit of these signals 21, 22.

The slope of the output RS of a ramp generator RAMP GEN, controlled by the digital signal processor DSP1, determines the frequency interval by which the IF signal input to the block CORDIC2 must be shifted.

The in-phase 21 and quadrature signals 22 are filtered using a filter for decimation and interpolation SINC (re.: [2]) and a pair of finite impulse response filters FIR, for channel equalization. A pair of corresponding filtered digital in-phase and quadrature signals 23, 24, is output.
[2] E. B. Hogenauer, "Economical class of digital filters for decimation and interpolation", *IEEE Trans. on Acoustics, Speech and Signal Processing,* Vol. ASSP-29, No. 2, April 1981.

Preferably, the signals 23, 24 are fed to the digital signal processor DSP1 for performing a further channel equalization, generating corresponding equalized in-phase 25 and quadrature 26 signals. The fact that the signals 23, 24 may be processed by a digital signal processor confers great flexibility to the receiver of this invention, because it is possible to change the equalization algorithm performed by the processor DSP1 depending on the characteristic of the transmission channel.

The processor DSP1 may be disabled or enabled by a logic signal LS, in order to switch to a reduced consumption functioning mode when desired. This may happen for example when only radio data service (RDS) signals are to be received and channel equalization operation performed by the processor DSP1 is not needed.

A multiplexer 19, controlled by a logic signal LS, is input with the two pairs of signals 23, 24 and 25, 26 and generates the signals I and Q to be fed to the first coordinate rotator-derotator CORDIC.

When the logic signal LS selects a low consumption functioning mode, the processor DSP1 is disabled and the multiplexer 19 outputs the pair of signals 23, 24, otherwise the processor DPS 1 is enabled and the multiplexer 19 outputs the pair 25, 26.

## Claims

1. A radio frequency receiver, comprising
a fully analog input tuning stage receiving radio frequency signals and generating corresponding intermediate frequency analog signals (IF-input);
an analog-to-digital converter (IFADC) of said intermediate frequency analog signals (IF-input) generating corresponding intermediate frequency digital signals;
a programmable digital signal processor (DSP1) managing the functioning of the receiver for generating demodulated digital signals;
an input interface (I2C SPI) coupled to said programmable digital signal processor (DSP1) for connecting it to an external device storing the software program to be run;
a digital down-converter (DDC) of said intermediate frequency digital signals, controlled by said programmable digital signal processor (DSP1) through a common bus, comprising at least
a coordinate rotator-derotator (CORDIC2) decomposing said intermediate frequency digital signals in corresponding in-phase (I) and quadrature (Q) low frequency digital signals;
a second coordinate rotator-derotator (CORDIC) input with said digital low frequency signals, providing to said digital signal processor (DSP1), through said common bus, signals representing phase (27), magnitude (28) and differential phase (29) of the complex signal represented by said digital in-phase (I) and quadrature (Q) signals (I+jQ).

2. The radio receiver of claim 1, wherein said first coordinate rotator-derotator (CORDIC) is controlled by a ramp signal (RS) the slope of which determines the frequency interval said intermediate frequency digital signals are to be shifted, and generates corresponding non filtered in-phase (I) and quadrature (Q) low frequency digital signals, and said digital down-converter (DDC) further comprises:
a digital filtering circuit composed of a filter for decimation and interpolation (SINC) and a pair of finite impulse response filters (FIR) for channel equalization coupled to said digital signal processor (DSP1), input with said digital in-phase (I) and quadrature (Q) low frequency signals and outputting corresponding filtered digital signals, and
a ramp generator (RAMP GEN) controlled by said digital signal processor (DSP1), generating said ramp signal (RS);
said second coordinate rotator-derotator (CORDIC) being input with said filtered in-phase (I) and quadrature (Q) low frequency digital signals.

3. The radio receiver of claim 1, further comprising
circuit means for decoding radio data service signals (RDS) coupled to said second coordinate rotator-derotator (CORDIC), providing said data service signals (RDS) through said input interface (I2C SPI) to an external microprocessor connected to the radio receiver;
a second programmable digital signal processor (DSP0) coupled to said input interface and to said first programmable digital signal processor (DSP1);
a serial audio interface (SAI) receiving and transmitting to said second programmable digital signal processor (DSP0) digital audio data;
a sample rate converter (SRC) coupled to said serial audio interface (SAI) that allows to modify the sample rate of data that the audio interface (SAI) transmits to the second programmable digital signal processor (DSP0);
a stereo decoding circuit (STEREO DECODER) coupled to said second programmable digital signal processor (DSP0), for specifically decoding FM stereo digital signals.

4. The radio receiver of claim 3, wherein said second programmable digital signal processor (DSP0) generates a digital feedback signal representative of the intensity of the currently received radio frequency signals, said receiver further comprising a digital-to-analog converter (DAC) input with said digital feedback signal generating a corresponding analog feedback signal provided to said input tuning stage for implementing an automatic gain control.

5. The radio receiver of claim 1, further comprising a high speed digital interface (HS3I) coupled to said common bus for interconnecting identical radio receivers and for providing to said digital signal processor (DSP1) replicas of internal digital signals generated by other receivers.

6. The radio receiver of claim 2, wherein said programmable digital signal processor (DSP1)
- is disabled by a logic signal (LS) selecting a low consumption functioning mode of the receiver,
- is input with said filtered digital signals (19) and
- performs further a channel equalization on said filtered digital signals (23, 24) generating corresponding equalized signals (25, 26),
said receiver further comprises a multiplexer (19) controlled by said logic signal (LS), input with said filtered digital signals (23, 24) and the corresponding equalized signals (25, 26), feeding said second coordinate rotator-derotator (CORDIC) with the filtered digital signals (23, 24) or with said equalized signals (25, 26) whether said logic signal (LS) selects a low consumption functioning mode of the receiver or not, respectively.
